Europäisches Patentamt

European Patent Office

Office européen des brevets

(11) Publication number : **0 612 979 A1**

## (12) EUROPEAN PATENT APPLICATION

(21) Application number : **94850029.3**

(22) Date of filing : **22.02.94**

(51) Int. Cl.⁵ : **G01B 21/00**

(30) Priority : **22.02.93 SE 9300582**

(43) Date of publication of application :
**31.08.94 Bulletin 94/35**

(84) Designated Contracting States :
**AT CH DE FR GB IT LI SE**

(71) Applicant : **LEINE & LINDE AB**
**Box 8**
**S-645 21 Strängäs (SE)**

(72) Inventor : **Linde, Henrik**
**Box 8**
**645 21 Strängnäs (SE)**

(74) Representative : **Hammar, Ernst et al**
**H. ALBIHNS PATENTBYRA AB**
**P.O. Box 3137**
**S-103 62 Stockholm (SE)**

(54) Sensor for indicating the position of a code organ relative to a detector.

(57)   The invention relates to a sensor unit comprising a patterned encoding device (12) and a detector device (14), wherein the detector device (14) and the encoding device (12) are displaceable in relation to one another, and wherein the detector device (14) is adapted to read the pattern on the encoding device (12) upon relative displacement between the detector device and the encoding device and produce a first encoding signal (10A, 10B) which indicates this mutual change in position. The sensor unit also includes a signal processing unit (40, 110, 60, 190) which is constructed to interpret the first encoding signal (10A, 10B) and to produce therefrom at least one digitally expressed output signal (U1 ; U2 ; U3, U4) containing a predetermined number of bits. The unit also includes adjustment means (110, 50, 190) which can be set to provide a selectable resolution of the digitally expressed output signal.

FIG.1B

The present invention relates to a device of the kind described in the preamble of Claim 1.

## BACKGROUND OF THE INVENTION

Optoelectrical position sensors may include an encoding disc having provided thereon some form of pattern which can be read optically. The disc pattern is read by one or more detectors which produce an electric signal relating to rotation or part rotation of the encoding disc.

The encoding disc either comprises an absolute encoding disc or an incremental encoding disc. An absolute encoding disc is provided with a pattern which is unique for each angular unit of rotation. Thus, when reading an absolute encoding disc, it is possible to establish the absolute angular positions of the disc. On the other hand, an incremental encoding disc is provided with a periodic pattern, for instance a pattern comprised of many light and dark fields of mutually equal size. When the incremental encoding disc is rotated or partially rotated, it is possible to detect the change between dark and light fields and therewith to read angular changes between the position of the disc.

## PROBLEMS WITH KNOWN TECHNIQUES

There is often a need to read angles with a given resolution within only a certain determined angular sector. According to known techniques, this need is satisfied by arranging a mechanical gear unit comprising gearwheels or like devices between a first axle whose position is to be measured and the axle on which the encoding disc is mounted. The gear unit functions to rotate the encoding disc through one full revolution when the first axle is rotated through an angle corresponding to the specific angular sector. When wishing to change the resolution of the angle measuring signal, it is necessary, when applying known techniques, to exchange the encoding disc for another encoding disc which has another resolution in the encoding disc pattern, or to replace the mechanical gear unit.

Changes of measuring angle sector are thus highly complicated when applying known techniques and require gearwheels to be fitted to and/or removed from a mechanical gear unit. The work involved in changing the resolution of the angle sensor is also complicated and requires mechanical replacement of an encoding disc.

## OBJECTS OF THE PRESENT INVENTION

The main object of the present invention to provide a sensor unit which will enable the resolution in the angle output signal of the sensor unit to be readily adjusted.

Another object of the present invention is to provide a sensor unit whose output signal includes a predetermined number of digital bits in combination with the possibility of readily adjusting the resolution in the sensor output signal.

Another object of the present invention is to provide a position sensor unit with which measuring is effected within one sector of the encoding device and with which the size of the sector can be adjusted.

A further object of the present invention is to provide a position sensor unit with which a starting position point can be adjusted.

Still another object of the present invention is to provide a position sensor which has an adjustable measuring range and with which measuring is effected in real time and the sensor output signal reacts quickly to movement of the measured object.

These objects, and other objects apparent from the following description, are achieved in accordance with the invention with a sensor unit of the type defined in the characterizing clause of Claim 1. Further features and further developments of the inventive device are apparent from the remaining Claims.

## BRIEF DESCRIPTION OF THE DRAWINGS

So that the present invention will be more readily understood and can be practiced more easily, the invention will now be described with reference to an exemplifying embodiment thereof and also with reference to the accompanying drawings, in which

Figure 1A is a block schematic of a sensor unit according to a first embodiment of the invention;

Figure 1B is a block schematic of a sensor unit according to a second embodiment of the invention;

Figure 2 illustrates schematically an encoding disc which can be included in a sensor unit according to Figure 1A or Figure 1B;

Figure 3A illustrates an example of a first signal delivered by a detector device which can be included in the sensor unit according to Figure 1A or Figure 1B;

Figure 3B illustrates an example of a second signal delivered by a detector device which can be included in the sensor unit according to Figure 1A or Figure 1B;

Figure 4 illustrates the output value of a first counter which can be included in the sensor unit according to Figure 1A or Figure 1B;

Figure 5 illustrates the output value of a second counter which can be included in the sensor unit according to Figure 1A or Figure 1B;

Figure 6 illustrates a number of memory blocks which store data that influences scaling between the output value of the first counter and the output signal of the sensor unit;

Figure 7 illustrates a data word stored in a memory block according to Figure 6;

Figure 8 illustrates a first memory block which includes a list of data bits which influence scaling between the output value of the first counter, according to Figure 4, and the output value of the second counter, according to Figure 5;

Figure 9 is a block schematic of a sensor unit according to a third embodiment of the invention;

Figure 10 illustrates a relationship between the counter value N of a counter means and a positional displacement X;

Figure 11 illustrates a relationship between the count value N of a counter means and a resolution ΔY of the sensor unit output signal; and

Figure 12 is a principle diagramme which illustrates one embodiment of a signal switching means.

## DETAILED DESCRIPTION OF THE FIRST EMBODIMENT

A first embodiment of the invention will now be described with reference to Figure 1A.

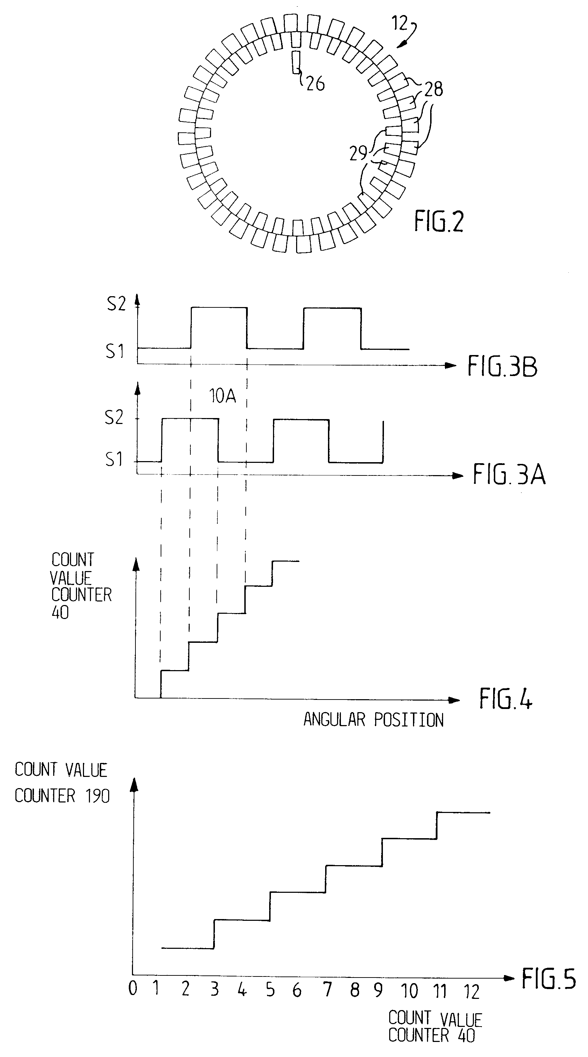

An inventive sensor unit 5 includes a first sensor device 10. The device 10 may include an incremental encoding disc 12 (see Fig. 1A or Fig. 2) and a detector device 14, wherein the disc 12 can be displaced in relation to the detector device 14 around a rotational point. The detector device may include one or more detector elements and is able to produce on an output 20 a signal 10A (Fig. 3) which corresponds to displacement of the encoding disc 12 in relation to the detector device 14.

The level of the output signal 10A will depend on the position of the incremental encoding disc 12. As the disc rotates, alternate dark parts and light parts pass the detector device 14 and in response thereto the detector device generates a first signal level S1 when a dark part is detected and a second signal level S2 when a light part is detected (see Fig. 3A).

The sensor device 10 is also intended to provide information relating to the direction in which the encoding disc 12 rotates. This can be achieved in several different ways. According to one embodiment, the output 20 is a multi-signal output which is able to deliver two output signals 10A and 10B respectively. The signal 10B is phase-shifted through 90° in relation to the signal 10A. (See Fig. 3A and Fig. 3B respectively). As the encoding disc rotates, the resultant signal combination and the signal which first has a positive or a negative edge provides information as to the direction in which the disc rotates, as is well known to the person skilled in this art. The direction of rotation of the disc 12 can also be detected by allowing first detector elements to detect a first group 28 of light and dark parts and allowing second detector elements to detect a second group 29 of light and dark parts on the encoding disc 12, said first group being displaced in relation to said second group, for instance in the manner illustrated in Fig. 2. The first detector elements can then produce the signal 10A in accordance with the pattern 28, and the second detector elements can produce the signal 10B in accordance with the pattern 29. According to an alternative embodiment, the phase-shifted signals 10A and 10B are produced by allowing the first and the second detector elements to read the same group of light and dark parts on the encoding disc but to displace the first and the second detector elements in relation to one another and thus detect a change in pattern with a time shift.

The output 20 of the sensor device 10 may be connected to an input B30 of a signal conversion unit B32. the signal conversion unit B32 may be constructed to scale the signal on the input B30 and to deliver a measurement signal to an output B33.

The signal conversion unit B32 may include a scaling select signal input B34, wherein a select signal, for instance in the form of a data word, delivered to the input B34 decides the relationship of the measurement signal on the output B33 with the signal on the input B30.

The data word delivered to the input B34 may decide the resolution of the measurement signal, the size of the measuring area, and the terminal points of the measuring area.

## THE SECOND EMBODIMENT

According to a second embodiment of the invention, the sensor device 10 may be constructed to produce a first zero angle signal in order to determine the position of the detector device 14 in relation to the encoding disc 12. This position may correspond, for instance, to a first zero angle. This enables an absolute zero angle to be established for a specific angular position. The zero angle signal, index pulse, can be produced on an output 25 of the sensor device 10 in response to the detector device detecting a zero angle pattern 26 on the encoding disc 12 (Fig. 2). This can be achieved in several ways, as is well known to the person skilled in this art. The encoding disc 12 may be provided with a zero angle pattern 26 which will produce a zero angle signal with each revolution of the disc, as illustrated in Fig. 2. However, the invention is not restricted hereto, and a zero angle signal can be produced two, three or more times with each revolution of the disc. This can be achieved by providing the encoding disc 12 with several zero angle patterns which are detected consecutively by a detector element as the disc rotates. Alternatively, it can be achieved with the aid of several detector elements which read or detect the same zero angle patterns and which are placed so that when the encoding disc is in a first position, a first detector element will produce a zero angle signal, and when the encoding disc is in a second position, a second detector element will produce a zero angle signal. All of these zero angle signals are produced on the output 25. Processing of the zero angle signal is described in more detail below.

According to the second embodiment of the invention, the output 20 of the sensor device 10 is connected with an input c10 of a conversion unit c20. The conversion unit converts the two phase-shifted signals 10A and 10B into input signals suitable for the signal edge counting means, as described below. According to one embodiment, information relating to the direction of disc rotation is obtained by a first output signal which produces pulses and a second output signal which provides the information positive rotational direction or negative rotational direction. According to another embodiment, count-up pulses are delivered on a first output and count-down pulses are delivered on a second output.

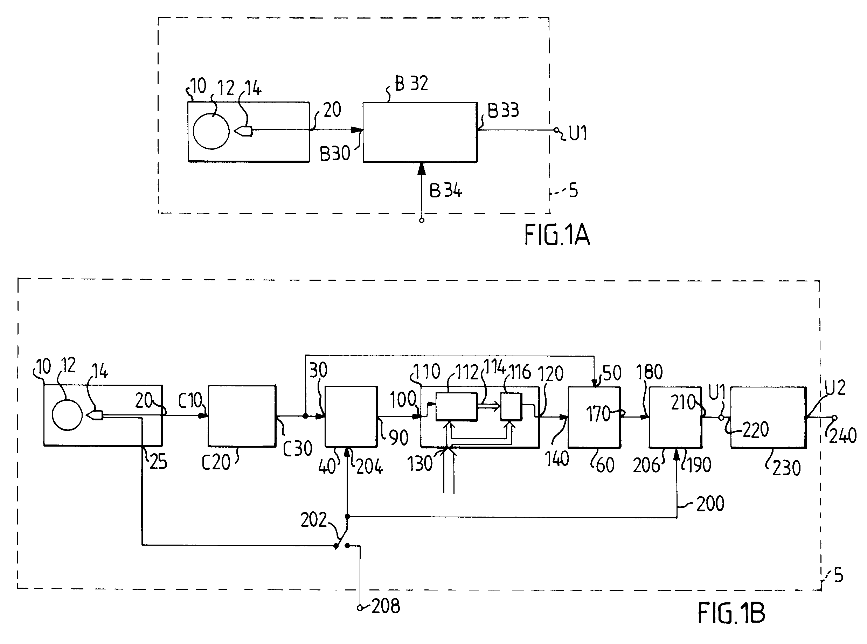

The conversion unit includes at least one output c30 which is connected to an input 30 of a first counter 40, as illustrated in Fig. 1B. The output c30 of the conversion unit is also connected to an input 50 of a signal switching means 60, as described in more detail below.

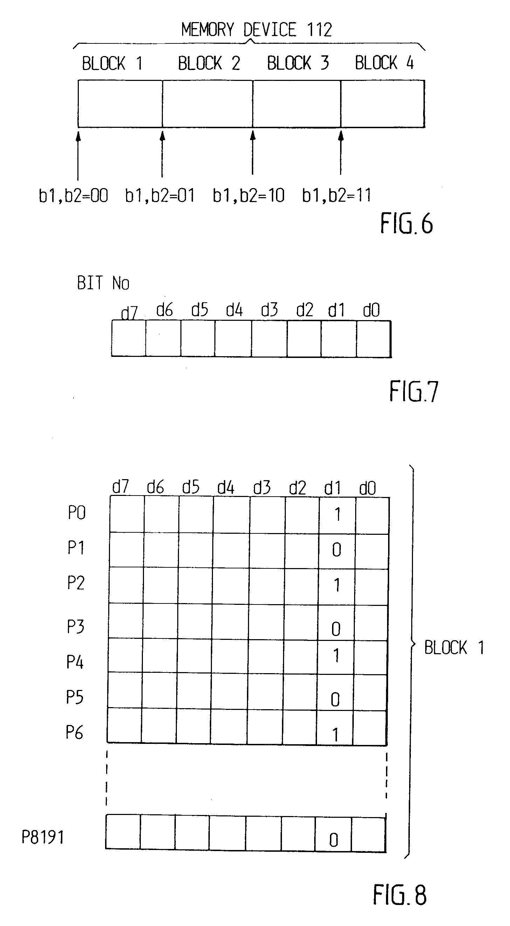

The conversion unit c20 may be constructed to detect both positive and negative edges on both of the pulse signals. Thus, four count-up or count-down increments are obtained on the output of the conversion unit during one period of the pulse signal 10A, as can be seen from Figs. 3A, 3B and Fig. 4 when taken together. Fig. 4 is a diagramme which illustrates the number of counts recorded on the counter 40 when counting is effected for each edge of the signals 10A and 10B. When the sensor device 10 delivers two phase-shifted pulse signals, which implies a two-bit Gray code where each pulse signal has 2048 periods with one revolution, there is thus obtained a basic resolution of 8192 parts with each revolution. The counter 40 is then able to deliver an output signal which includes 13 bits. The aforementioned digital values are given solely by way of example and, according to the present invention, the basic solution may be higher or lower than that stated and the number of bits in the counter output signal may also be different to that mentioned.

The counter 40 is thus able to generate a count value which is higher with positive rotation of the encoding disc 12, for example rotation in a clockwise direction in relation to the detector device, and lower when the encoding disc rotates in a negative sense, for instance rotates anti-clockwise in relation to the detector device. The count value of the counter 40 will thus correspond to the absolute angle of the encoding disc in relation to the detector device, and the counter 40 may be constructed to set the output signal to zero automatically when the input signal indicates an upward count at the same time as the output signal indicates the maximum count value. The count value of the counter 40 is produced on an output 90 which is connected to an input 100 of a selector device 110.

The selector device 110 may include a memory device 112, such as an EPROM, for instance. The count value delivered to the input 100 of the selector device 110 can be used as an address value. Depending on the address value obtained by the selector device 110 on the input 100, the selector device 110 will deliver a signal on an output 120.

The selector device 110 also includes an input 130, which is described in more detail below.

The output 120 of the selector device 110 is connected with an input 140 on the signal switching device 60. The signal switching device 60 may also include an output 170.

The signal switching device 60 is able to make or break a connection between the input 50 and the output 170 in dependence on the data signal on the input 140. This enables the signal switching device 60 to adjust the number of signal edges that are allowed to pass from the input 50 to the output 170 in dependence of signals on the input 140. This is described in more detail below.

The output 170 of the signal switching device 60 is connected to an input 180 of a second counter 190.

The second counter 190 is able to count the number of edges it receives on the input 180. The second counter 190 is also able to function in the same manner as that described with reference to the first counter 40, so as to count-up when the encoding disc rotates in a clockwise direction and to count down when the disc rotates in an anti-clockwise direction.

Both counters 40 and 190 can be set to zero by means of a start angle signal 200. The start angle signal 200 can be delivered from the output 25 of the sensor device 10 to zero setting inputs 104 and 206 of the counters 40 and 190 respectively, through the medium of a switching device 202. The switching device 202 may, for instance, be an operator controlled electronically controllable semiconductor switch. When the switching device 202 is in a position in which the output 25 is connected to the inputs 204 and 206, the counters 40 and 190 are set to zero when the detector elements detect the zero angle pattern 26 of the encoding disc 12.

The input signal on the input 130 of the selector device 110 determines the resolution of the output signal of the angle indicating unit 5. The same input signal also determines which measuring range shall be used. The input 130 may have the form of a bus input whose input signal, here called the resolution signal, may include five input signal bits, for instance. When each of these input signal bits is able to assume either a high or a low signal level, 32 combinations can be obtained. Thus, the resolution of the angle indicator can be chosen from among 32 different resolution alternatives, for instance. This can be achieved so that two bits b1, b2 in the resolution signal on the input 130 determine which of four different address blocks shall be used in the selector device 110. The remaining three bits b3, b4 and b5 and their individual functions are described in more detail below.

When the input signal on the input 130 of the selector device 110 is chosen to measure the angle linearly within one full revolution, i.e. when the chosen angular sector is 360 degrees, this means that when the output signal of the angle indicating unit is represented by eight bits, the resolution presented will be 360/256 = 1.40625 degrees. An angular sector of, for instance, 180 degrees can be chosen by producing another input signal on the input 130 of the selector device 110, wherewith the smallest angle presented may be 180/256 = 0.703125 degrees.

When the signal on the output 20 of the sensor device 10 provides information which corresponds to a division of one revolution into 8192 parts, the basic resolution will be 8192 parts with each revolution.

Thus, one of the selected measuring ranges may be:

Resolution        8192 parts/revolution
Scaling            Linear, 1:1
Sector angle      11.25 degrees

This means that absolute angles can be measured with a presented resolution of 360/8192 degrees within a sector angle of 11.25 degrees.

It is possible within the scope of the invention to set the start angle position of the selected angle sector. This is effected by means of a second zero angle signal, also called the sector start signal. When the switching device 202 is in a position in which a start angle signal input 208 is connected with the input 204 and 206, the counters 40 and 190 will be set to zero when an operator inserts a zero setting command through an operating panel, so as to cause a zero angle signal to be applied to the input 208.

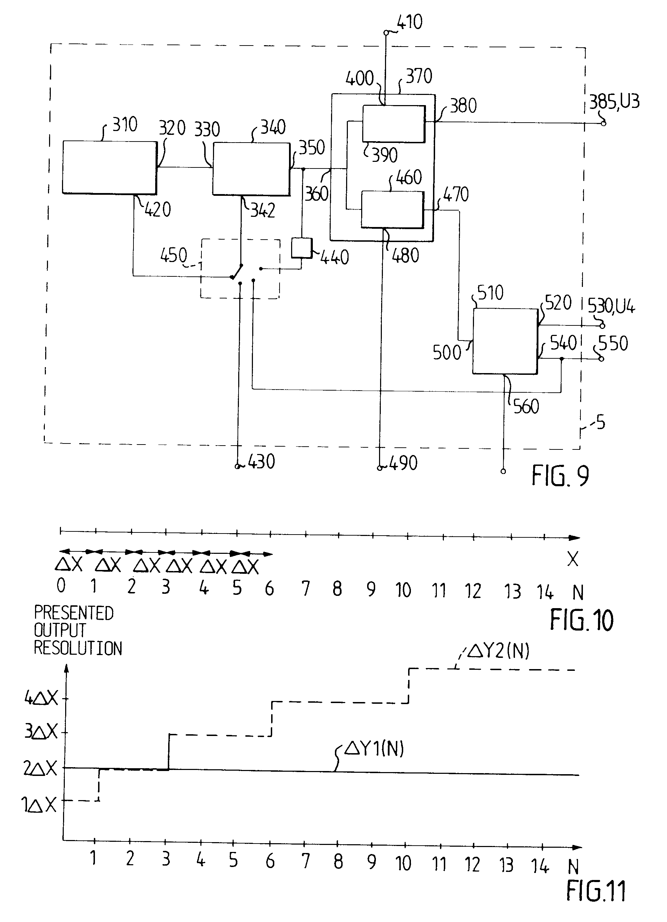

As before mentioned, the output signal of the counter 40 corresponds to the absolute angular position between the detector device 14 and the encoding disc 12. It is sometimes desirable to set the output signal of the sensor unit 5 to zero at a specific angular position, i.e. when a specific angle change has been obtained after zero setting with the aid of the signal on the input 108 or the output 25. This can be achieved by providing a decoding device (not shown in Fig. 1B; see Fig. 9) which produces in response to the output signal of the counter 40 a zero setting signal which sets the counter 190 to zero when the specific counter value is obtained on the output 90. For instance, the decoding device can generate the zero setting signal when the counter 40 delivers the value zero. It also lies within the scope of the invention for the counter 190 to be set to zero in response to several specific output signal states of the counter 40.

When the inventive optoelectric sensor unit is adjusted to a scaling factor of 1/2, the following takes place: Assume that the signal combination [b1, b2, b3, b4, b5] = [00 001] on the input 130 of the selector device 110 is the combination which relates to a halved resolution in the output signal of this embodiment of the sensor unit, i.e. 8192/2 = 4096 increments/revolution with an angle sector of 22.5 degrees. The two bits b1 and b2 on the input 130 then constitute the most significant bits in an address value and this address value points-out a first address block, block 1, in the memory device 112, as illustrated in Fig. 6. The count value on the input 100 constitutes the remaining bits in an address which points-out data in the memory device 112. The address can therefore include fifteen bits, wherein the 13 bits from the counter 40 point-out information within block 1 when the bits b1 and b2 are zero. Thus, when the counter 40 is able to count-up to a maximum of 8192, each address block will thus contain 8192 memory positions with data words. When the encoding disc is then rotated in a positive direction, the counter 40 steps upwards and the count value on the input 100 of the selector device 110 is used as an address value for pointing-out memory positions in the block 1. The memory device 112 delivers a data word on an output 114 in accordance with the fifteen address bits. The data word may include eight digital bits, for instance. The output 114 is connected to a bit selector device 116. The bit selector device 116 receives the data word from the memory device 112 and passes only one bit in the word to the output 120 of the selector device 110.

Figure 7 illustrates a data word comprised of eight bits, with bit positions d0, d1, d2, d3, d4, d5, d5, d6 and d7. The bits b3, b4 and b5 on the input 130 determine those bits d0-d7 which shall be passed to the output 120 by the bit selector device 116.

Thus, the output signal on the output 120 can be either a logic "one" or a logic "zero". A logic one informs the signal switching device 60 to connect the input 50 to the output 170. A logic zero informs the signal switching device 60 to break the connection between the input 50 and the output 170.

The output signal on the output 120 can change with each new memory position in the block concerned when, for instance, the bit d0 is chosen and when this bit is alternately "1" and "0" for consecutive memory positions p0, p1, p2... in a block (see Fig. 8, bit d1).

The second counter 190 thus produces an output signal U1 on an output 210 (see Fig. 5 and Fig. 1B respectively). The output signal U1 may, for instance, be a binary signal containing eight parallel bits. When the output signal U1 on the output 210 is not encoded with a Gray code, the output 210 may be connected to an input 220 of a code conversion device 230. The code conversion device 230 can convert the binary 8-bit signal from the counter 190 to a desired code, such as a Gray code for instance, and deliver this code on an output 240, as shown in Fig. 1B.

The bits b3, b4 and b5 in the signal on the input 130 are delivered to the bit selector device 116 as a control signal and determine which bit in the data word on the output 114 shall be passed to the output 120. For instance, the combination [b3, b4, b5] = [0,0,1] may be interpreted as a binary number with the base 2 and implies that bit D1 shall be passed to said output. Figure 8 illustrates the memory block 1 which includes a plurality of lists which control scaling between the count value of the first counter 40 and the count value of the second counter 230. An example of such a list is the bit combination 10101..0 in bit position d1 of the consecutive memory positions p0-p8191.

Thus, with reference to Fig. 8, the bit combination [b1, b2] = [0,0] on the input 130 of the selector device 110 means that block 1 has been selected. As before mentioned, the count value from the first counter 40 forms the address that points-out a memory position in the block selected in the memory device 112. This is illustrated in Fig. 8 by consecutive positions p0, p1...p8191 in block 1, wherein each such position contains a data word having the bits d0-d7. The bit combination [b3, b4, b5] = [0,0,1] can indicate that bit d1 in the data word at the memory position pointed-out shall be passed to the output 120.

Thus, suitable selection of bit combination in the list will enable scaling to be also adjusted to uneven scaling factors, such as $1/\pi$, for instance. The beginning of the bit list for scaling factor $1/\pi$ is:

[0010010010001.....

Logarithmic scaling or other non-linear scaling can thus be readily achieved by appropriate compilation of the bit list or the scaling list. It will be noted that an output signal which has selectable resolution and selectable measuring range, thus in accordance with the invention, can be obtained without complicated mechanical adjustment and without needing to provide the sensor unit with some form of microprocessor. It is thus possible to achieve the objects of the invention without applying time-consuming calculations such as multiplications and divisions.

## THE THIRD EMBODIMENT

According to a third embodiment, illustrated in Fig. 9, the sensor unit 5 includes a sensor device 310 which delivers on an output 320 a code signal which indicates when a positional change $\Delta X$ occurs between the encoding device and the detector device. The sensor device 310 may function as the earlier described encoding device 10 in combination with the conversion unit c20. The output 320 can be connected to an input 330 of a counter 340 which may be so constructed that its output signal N is a linear representation of the current positional displacement X between the detector device and the encoding device since the counter 340 was last set to zero. Figure 10 illustrates that the position displacement X corresponds to the counter value N multiplied by the position change of an increment or step $\Delta X$, where $\Delta X$ is the smallest step, i.e. the basic resolution:

$$X = N \cdot \Delta X.$$

The counter 340 can be set to zero when it receives a zero setting signal on an input 342, as described in more detail below.

When the sensor device 310 is an angle sensor, similar to the above-described angle sensing device 10, the output signal of the counter 340 is able to represent an angle of between 0 and 360 degrees, by virtue of measuring a counter value N between a minimum value MinCount, which is zero for instance, and a maximum value, here called MaxCount. Alternatively, the sensor device may be a length sensor, wherein the encoding device is a generally rectilinear rod or staff provided with an encoding pattern, and wherein the sensor device also includes a detector means which may be displaceable in relation to the encoding staff.

The output signal of the counter 340 can be produced on an output 350 which may be connected to an input 360 of a signal transform unit 370 (Fig. 9). The signal transform unit is able to generate a first digital output signal having a given number of bits on a first multi-signal output 380 in response to the signal state or count value on the input 360. The digital output signal on the output 380 may be a data word which represents the absolute state of the detector device in relation to the sensor device. This is described in more detail below. The output 380 can be connected to an output connection 385 which can form a first output for absolute state from the sensor unit 5.

The signal transform unit 370 may include a first memory device 390, wherein the count value on the input 360 constitutes the least significant bits of an address value Addr1 which points-out in the memory device 390 the data word that shall be delivered on the output 380. The most significant bits in the address value Addr1 can be entered on a separate input 400 and it is these bits which determine the address block from which the data words delivered on the output 380 are taken. The input 400 may be connected to an input connection 410 to which a user is able to deliver a first measuring selection signal. The memory device 390 may be provided with suitable data words on consecutive memory positions so that those data words delivered consecutively on the output 380 as the count value on the input 360 runs from MinCount to MaxCount will represent the function values of a selected function of the applicable position displacement between the detector device and the encoding device. Thus, there is obtained on the output connection 385 signal values which represent the value of a linear or non-linear function F(X) in accordance with the position X. A first address block may include MaxCount numbers of consecutive memory positions which include the function values $F_1$ (MaxCount). Similarly, a second address block may include the function values of a second function $F_2$ (N), and so on. A change in the signal U3 on the output 385 will thus have a specific function relationship with a change in the counter value N and therewith a specific function relationship with a change in the position X. The output signal U3 is thus a discrete function of the counter value N.

When MinCount is 0 and MaxCount is 8191, it is possible to adjust the sensor unit to a measuring range with a variable output signal, for instance for positions corresponding to the counter values 0 to 200, by entering a measuring selection signal, i.e. the most significant bits in the address value, on the input 410, so that the words delivered will be taken from a memory block in which the value of the words in the chosen 201 memory positions will stand in particular relationship with the counter value N, and the words in the memory positions 201 to 8191 will correspond solely to the zero value. The inventive sensor unit can be preprogrammed with a large number of measuring ranges, by providing the memory devices 390 and 460 with a large number of memory blocks of which each block will implement one measuring range.

When the counter 340 has been reset by means of the zero setting signal on the input 342, the counter will thus deliver the count value N = MinCount and a function value F(MinCount) is delivered on the output 385. The zero setting signal may have its origin from the zero setting signal output 420 of the sensor device 310, similar to the manner described above with reference to the sensor device 10. Alternatively, the zero setting signal can be delivered from an input connection 430 or from a decoding device 440. The source of the zero setting signal can be chosen by a user with the aid of an adjustable signal switching device 450. The decoder 440 includes a signal input which can be connected to the counter output 350, and the decoder 440 is able to generate a zero setting signal in accordance with a specific counter value on the output 350.

The signal transform unit 370 may also include a second memory device 460, wherein the count value on the input 360 forms the least significant bits of an address value Addr2 which points-out in the memory device 460 the data word to be delivered on an output 470. The most significant bits in the address value Addr2 can be entered on a separate input 480, these bits determining the address block in the second memory device 460 from which the data words delivered on the output 470 shall be taken. The input 480 can be connected to an input connection 490 to which a second measuring selection signal can be fed by a user.

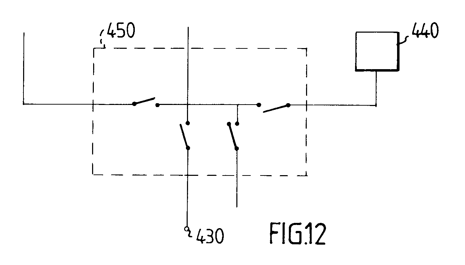

The output 470 can be connected to an input 500 of a bit selector device 510. The bit selector device 510 may be provided with a multi-signal output 520, which can be connected to an output connection 530. The bit selector device 510 can deliver, for instance, two bits on the multi-signal output 520 chosen from the data word on the input 500, by picking-out, for instance, bit d0 and bit d1 (see Fig. 7). Thus, the signal on the multi-signal output 520 can represent an incremental signal when consecutive data words are delivered to the input 500. This incremental signal can therewith be a rescaled representation of the positional change between the detector device 14 and the encoding device 12 (see Fig. 1B). There can therewith be obtained on the output 520 an incremental signal having a second resolution $\Delta Y1$ which can differ from the basic resolution $\Delta X$, as illustrated in Figure 11. By appropriate selection of the bits in the data words at consecutive memory positions in the memory device 460, the incremental signal on the output 520 may be given a resolution $\Delta Y2(N)$ which

7

varies as a function of the count value N and therewith as a function of the positional displacement X, as illustrated in Fig. 11. For instance, the resolution $\Delta Y2$ as a function of N = 0 may be $\Delta X$, and the resolution $\Delta Y2$ as a function of N = 1 or N = 2 may be $2*\Delta C$, while the resolution $\Delta Y2$ as a function of N = 3, 4 or 5 may be $3*\Delta X$, and so on.

The bit selector device 510 (see Fig. 9) may also include an output 540 which can deliver a zero setting pulse or an index pulse in accordance with the value of a specific bit, such as bit d3 (Fig. 7), for instance, in the data word on the input 500. Thus, a zero setting pulse can be readily obtained in accordance with a given count value N of the counter 340, and therewith in accordance with a given positional displacement X. The output 540 may also be connected to an output connection 550 with which a user can obtain direct access to the zero setting pulse. The output 540 may also be connected to a pole or terminal of the signal switching device 450, so as to enable the output 540 to be connected to the zero setting input 342 of the counter 340.

Figure 12 illustrates a principle diagram illustrating one embodiment of the signal switching device 450. The switching device comprises a number of switches which enable the selection of which index pulse or which index pulses of the aforedescribed index pulses shall be applied to the zero setting input of the counter.

Thus, the signal transform unit 370 illustrated in Fig. 9 may include two memory devices of which one memory device 340 delivers an absolute position signal U3 and the other memory device 460 delivers a digital word which can be used to produce an incremental encoding signal U4 and an index pulse.

The bit selector device 510 may also be adjustable with the aid of a signal applied to an input 560, so that a user is able to determine which bit positions in the word on the input 500 shall be delivered to the respective outputs 520 and 540.

## Claims

1. A sensor unit comprising a patterned encoding device (12) and a detector device (14), wherein the detector device (14) and the encoding device (12) can be displaced relative to one another, and wherein the detector device (14) is adapted to read the pattern on the encoding device (12) when displaced in relation thereto and therewith produce a first encoding signal (10A, 10B) which indicates the relative change in position of said devices, **characterized** by a signal processing unit (B32; 40, 110, 60, 190; 340, 370, 510, 440) which is constructed to interpret the first encoding signal (10A, 10B) and to produce therefrom at least one digitally expressed output signal (U2; U3, U4) containing a predetermined number of bits; and in that the signal processing unit includes setting devices (110, 50, 190; 440, 450, 400, 490, 560) which can be adjusted to provide selectable resolution of the digitally expressed output signal (U2; U3, U4).

2. A unit according to Claim 1, **characterized** in that the signal processing unit (B32; 40, 110, 60, 190; 340, 370, 510, 440) functions to change the digitally expressed output signal (U2; U3, U4) in accordance with a change in the first encoding signal (10A, 10B), wherein the change in the digitally expressed output signal (U2; U3, U4) has a specific function relationship with the positional change between the detector device and the encoding device.

3. A unit according to Claim 2, **characterized** in that the signal processing unit (B32; 40, 110, 60, 190; 340, 370, 510, 440) includes at least one first counter device (40; 340) which functions to produce a count value in accordance with the first encoding signal (10A, 10B) and to deliver the count value to a count value output (210; 350); in that the counter device steps-up the count value in response to a first type of change in the first encoding signal (10A, 10B), and steps-down the count value in response to a second type of change in the first encoding signal (10A, 10B); in that the counter device includes a resetting input (204; 342) and can be reset by means of a resetting signal applied to the reset input; and in that the digitally expressed output signal (U2; U3, U4) is dependent on the count value.

4. A unit according to Claim 3, **characterized** in that the signal processing unit (B32; 40, 110, 60, 190; 340, 370, 510, 440) functions to cause the digitally expressed output signal (U2; U3, U4) to change in accordance with the count value within at least one given count value range, wherein the count value range is defined by a first limit count value which corresponds to a first position, and a second limit count value which corresponds to a second position.

5. A unit according to Claim 4, **characterized** in that the signal processing unit (B32, 40, 110, 60, 190; 340, 370, 510, 440) causes the digitally expressed output signal (U2; U3, U4) to be kept constant when the count value does not lie within said specific count value range.

6. A unit according to Claim 4 or 5, **characterized** in that the signal processing unit (B32; 40, 110, 60, 190; 340, 370, 510, 440) includes at least one first memory device (112; 460) which includes a number of memory positions which have addresses and are provided with digital words; in that the count value output of the first counter device is connected to the address input of the first memory device such that the first memory device (112; 460) will deliver the digital word which is stored on the address value constituted by the count value; and in that the digital word in each memory position is in a specific function relationship with corresponding count values, i.e. the value of a specific digital word is a function of a corresponding count value.

7. A unit according to Claim 4, 5 or 6, **characterized** in that the first count limit value is the count value that is generated by the first counter device after resetting, and the second count limit value is the address value after which the words in memory positions having consecutively higher addresses coincide with one another.

8. A unit according to Claim 4, 5, 6 or 7, **characterized** in that the sensor device (10; 310) generates the resetting signal; and in that the resetting signal is delivered to the reset input of the counter device.

9. A unit according to Claim 4, 5, 6, 7 or 8, **characterized** by a decoding device (440) which reads the count value of the counter device (340) and generates a reset signal at at least one pre-settable return count value and delivers the reset signal to the reset input (342) of the counter device (340) so that the count value and the digitally expressed output signal adopt their respective reset values.

10. A unit according to Claim 4, 5, 6, 7, 8 or 9, **characterized** by an adjustable bit selector device (116; 510) which is constructed to sort out an index bit from the digital word delivered by the first memory device; and in that the bit selector device includes an index bit output (540, 550), wherein the signal level on the index bit output corresponds to the value of the index bit.

11. A unit according to Claim 10, **characterized** in that a first signal level on the index bit output (540) initiates a zero setting signal and a second signal level does not initiate a zero setting signal.

12. A unit according to Claim 6, 7, 8, 9, 10 or 11, **characterized** in that the digitally expressed output signal (U2; U3, U4) is comprised of at least two bits in the digital word delivered from the first memory device; and in that the digitally expressed output signal is coded with a Gray code.

13. A unit according to any one of the preceding Claims, **characterized** in that the digitally expressed output signal (U4) is a word containing two bits which with the aid of the adjustable bit selector device (510), which includes a first and a second bit output, are sorted-out from the digital word obtained from the first memory device (460) and delivered to the first and the second bit output respectively; and in that the two-bit word is an incremental encoding signal (U4) which indicates a relative change in position between the detector device (14) and the encoding device (12) with a resolution which differs from the resolution of the first encoding signal (10A, 10B).

14. A unit according to any one of Claims 1-12, **characterized** in that the digitally expressed output signal (U2, U3) is an absolute position value which indicates the absolute position of the encoding device (12) in relation to the detector device (14).

15. A unit according to any one of the preceding Claims, **characterized** in that the first encoding signal includes at least two mutually phase-shifted part-signals (10A, 10B); in that the first counter device counts the number of edges of the part-signals in the first encoding signal (10A, 10B), wherein the first counter device counts-up in a first phase-relationship between the part-signals, and wherein the first counter device counts-down in a second phase-relationship between the part-signals.

16. A unit according to any one of the preceding Claims, **characterized** in that the adjusting device (110, 50, 190; 440, 450, 400, 490, 560) includes the first memory device (112; 390, 460); and in that the memory device includes a second address input (400, 480), wherein the address value on the second address input constitutes the most significant bits in the memory address of the first memory device; in that the count value of the first counter device (40, 340) constitutes the least significant bits in the memory address of the first memory device; and in that the address value on the second address input (400, 480) can be adjusted and is therewith the measuring range of the sensor unit, and scaling of the output signal can be

9

adjusted.

17. A unit according to any one of the preceding Claims, **characterized** in that the encoding device is an encoding disc (12) and the sensor unit (5) is an angle sensor unit.

18. A unit according to any one of Claims 1-16, **characterized** in that the encoding device is an encoding staff and the sensor unit (5) is a length sensor unit.

FIG.1A

FIG.1B

FIG.2

FIG.3B

FIG.3A

COUNT
VALUE
COUNTER
40

FIG.4

ANGULAR POSITION

COUNT VALUE
COUNTER 190

FIG.5

0 1 2 3 4 5 6 7 8 9 10 11 12

COUNT VALUE
COUNTER 40

MEMORY DEVICE 112

| BLOCK 1 | BLOCK 2 | BLOCK 3 | BLOCK 4 |
|---|---|---|---|
| | | | |

b1,b2=00  b1,b2=01  b1,b2=10  b1,b2=11

FIG.6

BIT No

| d7 | d6 | d5 | d4 | d3 | d2 | d1 | d0 |
|---|---|---|---|---|---|---|---|
| | | | | | | | |

FIG.7

| | d7 | d6 | d5 | d4 | d3 | d2 | d1 | d0 |
|---|---|---|---|---|---|---|---|---|
| P0 | | | | | | | 1 | |
| P1 | | | | | | | 0 | |
| P2 | | | | | | | 1 | |
| P3 | | | | | | | 0 | |
| P4 | | | | | | | 1 | |
| P5 | | | | | | | 0 | |
| P6 | | | | | | | 1 | |
| P8191 | | | | | | | 0 | |

BLOCK 1

FIG.8

FIG. 9

FIG.10

PRESENTED
OUTPUT
RESOLUTION

FIG.11

14

450

440

430

FIG.12

EP 0 612 979 A1

| European Patent Office | EUROPEAN SEARCH REPORT | Application Number EP 94 85 0029 |

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| Y | DE-C-38 15 534 (HEIDELBERGER DRUCKMASCHINEN AG.) --- | 1 | G01B21/00 |
| Y | DE-C-39 32 800 (HENGSTLER GMBH) ----- | 1 | |

TECHNICAL FIELDS SEARCHED (Int.Cl.5)

G01B
G01D
G08C
H03M

The present search report has been drawn up for all claims

| Place of search | Date of completion of the search | Examiner |
|---|---|---|
| STOCKHOLM | 16 May 1994 | INGEMAR JOSEFSSON |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

16